# EUROPÄISCHE PATENTANMELDUNG

(11) **EP 2 639 720 A2**
(43) Veröffentlichungstag der Anmeldung: **18.09.2013**
(21) Anmeldenummer: 13158226.4
(22) Anmeldetag: 07.03.2013
(51) Int. Cl.: G06F 17/50

(54) **Verfahren zur Konstruktion mechanischer Komponenten**

(30) Priorität: 13.03.2012 DE 102012203869
(71) Anmelder: Fraunhofer-Gesellschaft zur Förderung der Angewandten Forschung e.V., 80686 München (DE)
(72) Erfinder: Jaeger, Raimund, 79108 Freiburg im Breisgau (DE); Koplin, Christof, 79112 Freiburg im Breisgau (DE); Ziegler, Tobias, 79100 Freiburg im Breisgau (DE)
(74) Vertreter: Goeden, Christian

(57) **Zusammenfassung**

Die Erfindung betrifft ein Verfahren zur Konstruktion mechanischer Komponenten (10), enthaltend die folgenden Schritte: Festlegen (51) der Außenkontur (12) der mechanischen Komponente (10); Diskretisieren (52) des Volumens der mechanischen Komponente (10) in eine Mehrzahl von Zellen (15); Bestimmen (53) der mechanischen Spannung in zumindest einer Zelle (15) unter zumindest einer Belastung (F); Ersetzen (54) von zumindest einer Zelle (15) durch zumindest ein Strukturelement (20, 21, 22), wobei die Strukturelemente ausgewählt sind aus Polyedern und/oder Trabekeln und ein Polyeder kleiner ist als das Volumen einer Zelle (15).

## Beschreibung

Die Erfindung betrifft ein Verfahren zur Konstruktion mechanischer Komponenten, bei welchem ein Modell der mechanischen Komponente in eine Mehrzahl von Zellen diskretisiert wird und die mechanische Spannung in zumindest einer Zelle unter zumindest einer Belastung bestimmt wird.

Aus der Praxis sind bionische Konstruktionsverfahren bekannt, bei welchen die innere Struktur eines Bauteiles belastungsabhängig konstruiert wird. Das Ergebnis dieser Verfahren sind meist unregelmäßige Strukturen, welche an den Stellen größerer Belastung einen größeren Materialeinsatz zeigen als an den Stellen geringerer Belastung. Solche Strukturen können zwar die eingeleiteten Belastungen abtragen, sind jedoch aufgrund ihrer Komplexität einer rechnerischen Analyse nicht mehr zugänglich. Aufgrund der Komplexität der Struktur kommt nämlich eine analytische Berechnung nicht mehr in Frage. Für eine numerische Simulation müsste die gesamte Mikrostruktur aufwändig diskretisiert werden, was zeitaufwändig und fehleranfällig ist. Oftmals konvergieren solche aufwändigen Rechenmodelle nicht oder nur langsam. Zur Beurteilung der Festigkeit müssen daher meist Versuchsstücke gefertigt und in entsprechenden Belastungstests geprüft werden. Insbesondere bei Kleinserien ist dieses Vorgehen unwirtschaftlich.

Ausgehend von diesem Stand der Technik liegt der Erfindung daher die Aufgabe zugrunde, ein Verfahren zur Konstruktion mechanischer Leichtbaukomponenten anzugeben, welche einerseits in einem generativen Fertigungsverfahren herstellbar sind und deren mechanische Belastbarkeit ohne aufwändige Versuche vorhersagbar ist.

Die Aufgabe wird erfindungsgemäß durch ein Verfahren gemäß Anspruch 1 gelöst.

Erfindungsgemäß wird vorgeschlagen, die Außenkontur der mechanischen Komponente in einem ersten Verfahrensschritt festzulegen. Die mechanische Komponente kann beispielsweise ein Maschinenelement, ein Möbelstück oder ein Zahnersatz sein. Sofern die mechanische Komponente ein Maschinenelement ist oder ein solches enthält, kann es sich um ein Zahnrad, einen Kolben, ein Wälz- oder Gleitlager, eine Kurbelwelle, ein Gehäuse, ein Exzenter, ein Werkzeug oder ein anderes, an sich bekanntes Bauteil handeln. Beispielsweise kann die mechanische Komponente Teil einer Brennkraftmaschine, einer Werkzeugmaschine oder eines beliebigen anderen Gerätes sein. Aufgrund des möglichen geringen Gewichtes der vorgeschlagenen mechanischen Komponenten eignen diese vorteilhaft für den Einsatz in Fahr- oder Flugzeugen.

Sofern die mechanische Komponente aufgrund der Funktion zwingend eine geschlossene Oberfläche benötigt, so kann die Außenkontur mit einer vorgebbaren Wandstärke versehen werden. Sofern eine geschlossene Oberfläche aufgrund der Funktion nicht zwingend erforderlich ist, kann die Außenkontur der mechanischen Komponente als virtuelle Linie bzw. rein gedankliches Konzept vorgegeben werden. Erfindungsgemäß wird nun vorgeschlagen, das Volumen der mechanischen Komponente bzw. das nach Abzug der Wandstärke verbleibende Volumen in eine Mehrzahl von Zellen zu diskretisieren. Dies kann entweder durch einen Benutzereingriff oder durch einen automatischen Netzgenerator erfolgen, welcher die mechanische Komponente mit regelmäßig oder unregelmäßig geformten Teilvolumina auffüllt.

In einigen Ausführungsformen der Erfindung kann die Größe und/oder Form eines Teilvolumens von der Größe und/oder Form eines oder mehrerer benachbarter Teilvolumina abhängig sein. Im nächsten Verfahrensschritt wird die mechanische Spannung in zumindest einer Zelle unter zumindest einer Belastung bzw. einem Lastfall bestimmt. Zur Bestimmung der mechanischen Spannung kann ein Vorgabewert der Steifigkeit bzw. des Elastizitätsmoduls gewählt werden. Sofern aus Vorversuchen und/oder Vorerfahrungen bzw. der geplanten Materialwahl für die mechanische Komponente ein Wert der Steifigkeit bzw. des Elastizitätsmoduls bekannt ist, kann dieses Vorwissen in die Wahl der für die Berechnung verwendeten Steifigkeit einbezogen werden.

Nachdem die mechanische Spannung in zumindest einer Zelle bestimmt wurde, wird im letzten Verfahrensschritt zumindest eine Zelle durch ein Strukturelement ersetzt. In einigen Ausführungsformen der Erfindung kann das Verfahren zyklisch wiederholt werden bis alle Zellen durch jeweils zumindest ein Strukturelement ersetzt sind oder bis die entstehende Struktur eine hinreichende Festigkeit aufweist, um beim gegebenen Lastfall eine hinreichende Festigkeit der mechanischen Komponente sicherzustellen. Auf diese Weise kann die innere Struktur der mechanischen Komponente so festgelegt werden, dass die mechanische Komponente die ihr zugedachte Funktion erfüllen kann und dennoch gegenüber einer massiven Bauweise Material und Gewicht eingespart wird. Sofern die Außenkontur nicht von Anfang an mit einer vorgebbaren Wandstärke versehen wurde, bilden die Außenflächen der an der Oberfläche der mechanischen Komponente angeordneten Strukturelemente die Oberfläche der mechanischen Komponente, welche in diesem Fall nicht notwendigerweise geschlossen sein muss.

In einigen Ausführungsformen der Erfindung kann die Mehrzahl von Zellen so gewählt sein, dass jede einzelne Zelle eine identische Größe aufweist. Dies führt dazu, dass die durch das Verfahren bereitgestellte innere Struktur der mechanischen Komponente regelmäßig ist. Eine solche regelmäßige bzw. gleichmäßige Struktur ist in besonders einfacher Weise einer Berechnung zugänglich, so dass oftmals auf die Herstellung eines Prototypen verzichtet werden kann.

In einigen Ausführungsformen der Erfindung kann jede Zelle durch genau ein Strukturelement ersetzt werden. Auch dieses Merkmal trägt dazu bei, die Struktur gleichmäßig zu erzeugen, so dass die Belastbarkeit der mechanischen Komponente einfach vorhergesagt werden kann.

In einigen Ausführungsformen der Erfindung kann das in eine Zelle einzusetzende Strukturelement aus einer Mehrzahl möglicher Strukturelemente ausgewählt werden. Dies erlaubt eine Anpassung der Struktur in unterschiedlichen Belastungszonen, ohne dass die für eine Vorhersage der Belastbarkeit wichtige Gleichmäßigkeit der Mikrostruktur der mechanischen Komponente verloren geht.

In einigen Ausführungsformen der Erfindung können sich unterschiedliche Strukturelemente in ihrer Größe und/oder in ihrer Form und/oder in ihrem Querschnitt und/oder in ihrem Material und/oder im Anteil des ausgefüllten Volumens unterscheiden. Auf diese Weise kann ein Strukturelement größerer Belastbarkeit eingesetzt werden, wenn die mechanische Spannung in einer Zelle besonders groß ist. Sofern die berechnete Spannung in der jeweiligen Zelle nur gering ist, kann ein Strukturelement geringerer Belastbarkeit und geringerem Gewicht eingesetzt werden. Hierdurch wird eine leichte und steife Struktur bereitgestellt, welche durch ihren regelmäßigen bzw. zyklischen inneren Aufbau dennoch einer Berechnung zugänglich ist.

In einigen Ausführungsformen der Erfindung können die Strukturelemente ausgewählt sein aus Polyedern und/oder Trabekeln und/oder non-uniform rational B-Splines (NURBS). Ein Polyeder kann als gleichmäßiger oder ungleichmäßiger Körper ausgestaltet sein, entsprechend der Geometrie der jeweiligen Zellen. Sofern ein Polyeder wesentlich kleiner ist als das Volumen einer Zelle, kann eine unterschiedliche Anzahl von Polyedern in jede Zelle eingefügt werden, je nach auftretender Belastung der jeweiligen Zelle. Im Extremfall kann eine Zelle vollständig mit Polyedern ausgefüllt sein, um an dieser Stelle der mechanischen Komponente die maximale Belastbarkeit zu gewährleisten.

Unter einem Trabekel wird für die Zwecke der vorliegenden Beschreibung ein bälckchen- oder strangartiges Bündel von Material verstanden, welches eine Mehrzahl von Kontaktpunkten aufweist und Kräfte, welche über zumindest einen Kontaktpunkt eingeleitet werden, auf zumindest einen anderen Kontaktpunkt abträgt.

Unter non-uniform rational B-Splines (NURBS) werden Körper verstanden, deren Begrenzungsflächen über stückweise funktional definierte Geometrie-Elemente definiert sind. NURBS-Flächen können folgende Vorteile aufweisen: Sie können invariant für projektive Transformationensein, eine gemeinsame mathematische Darstellung für sowohl analytische Standardformen (z. B. Kegelschnitte) als auch Freiformflächen bieten und den Speicheraufwand für geometrische Objekte reduzieren. Weiterhin können NURBS-Flächen durch numerisch stabile und präzise Algorithmen schnell ausgewertet werden, so dass der Rechenaufwand für das Verfahren reduziert sein kann.

In einigen Ausführungsformen der Erfindung kann zumindest ein Polyeder ausgewählt sein aus einem Tetraeder und/oder einem Hexaeder und/oder einem Oktaeder und/oder einem Dodekaeder und/oder einem Ikosaeder. Diese Polyeder sind als platonische Körper aufgrund ihrer Symmetrie besonders einfach in die jeweiligen Zellen einzufügen und die Belastbarkeit ist leicht berechenbar. Aufgrund ihrer planen Begrenzungsflächen können diese Körper zuverlässig Kräfte auf benachbarte Körper in benachbarten Zellen übertragen.

In einigen Ausführungsformen der Erfindung kann das Verfahren als weiteren Schritt das Diskretisieren der Strukturelemente in eine Mehrzahl von Zellen und das Bestimmen der mechanischen Spannung in zumindest einem Strukturelement unter zumindest einer vorgebbaren Belastung enthalten. Da das erfindungsgemäße Verfahren eine gleichmäßige Struktur bereitzustellen vermag, kann diese besonders einfach diskretisiert werden, um die Belastbarkeit der in den vorherigen Verfahrensschritten generierten mechanischen Komponente zu bestimmen. Hierdurch können aufwändige Versuche vermieden werden, so dass die Fertigung von Kleinserien besonders wirtschaftlich ist.

In einigen Ausführungsformen der Erfindung kann das Bestimmen der mechanischen Spannung in zumindest einer Zelle unter zumindest einer Belastung mittels einer Finiten-Elemente-Methode und/oder einer Finiten-Volumen-Methode und/oder einer Smoothed-Particles-Hydrodynamic-Methode erfolgen. Diese Verfahren bieten einerseits eine rasche Konvergenz und eine gute numerische Stabilität und können aufgrund ihrer weiten Verbreitung einfach eingesetzt werden.

In einigen Ausführungsformen der Erfindung kann die in den vorhergehenden Schritten ermittelte Struktur an ein generatives Fertigungsverfahren ausgegeben werden. Unter einem generativen Fertigungsverfahren soll für die Zwecke der vorliegenden Beschreibung ein Verfahren zur Urformung verstanden werden, bei welchem die mechanische Komponente schichtweise aufgebaut wird.

In einigen Ausführungsformen der Erfindung kann das generative Fertigungsverfahren ausgewählt sein aus dreidimensionalen Drucken und/oder Elektronenstrahlschmelzen und/oder fused deposition modelling und/oder selektivem Laserschmelzen und/oder selektivem Lasersintern und/oder Space Puzzle Molding und/oder Stereolithografie. Die genannten Verfahren eignen sich sowohl zur Fertigung von Prototypen als auch zur Herstellung von Kleinserien.

In einigen Ausführungsformen der Erfindung kann die mechanische Komponente ein Volumen von weniger als 50000 cm³ oder von weniger als 10000 cm³ oder von weniger als 5000 cm³ oder von weniger als 1000 cm³ oder von weniger als 500 cm³ oder von weniger als 100 cm³ oder von weniger als 10 cm³ aufweisen. Das vorgestellte Konstruktionsverfahren eignet sich insbesondere zur Herstellung von kleinen Bauteilen und geringen Stückzahlen, wie beispielsweise Zahnersatz. Bei diesen Bauteilen kann durch das Unterteilen in gleichmäßige Zellen und die klare Aufbauregel des Ersetzens einzelner Zellen durch Strukturelemente eine regelmäßige Struktur erzielt werden, welche dadurch mit üblichen Rechenverfahren simuliert werden kann und auf diese Weise eine vorhersagbare Belastbarkeit und/oder Lebensdauer aufweisen kann.

In einigen Ausführungsformen der Erfindung kann eine Zelle ein Volumen von weniger als 50 cm³ oder von weniger als 10 cm³ oder von weniger als 1 cm³ oder von weniger als 0,1 cm³ aufweisen. Je kleinteiliger dabei die Zelle gewählt ist, umso feinere Strukturen können mit dem vorgeschlagenen Verfahren erzeugt werden. Hierdurch kann sich eine besonders gute Anpassung der Struktur in unterschiedlichen Belastungszonen der mechanischen Komponente ergeben.

In einigen Ausführungsformen der Erfindung kann das erfindungsgemäße Verfahren in einem Computerprogramm implementiert sein. In diesem Fall weist das Computerprogramm einen Programmcode auf, welcher zur Ausführung des Verfahrens ausgebildet ist, wenn das Computerprogramm auf einem Computer ausgeführt wird.

In einigen Ausführungsformen der Erfindung betrifft diese einen Datenträger mit darauf gespeicherten Daten oder für die Übersendung über ein Computernetzwerk geeignete, Daten repräsentierende Signalfolge, wobei die Daten ein Programm zur Ausführung auf einem Mikroprozessor darstellen, wobei das Programm einen Programmcode aufweist, welcher zur Ausführung des vorgeschlagenen Verfahrens ausgebildet ist, wenn das Computerprogramm auf einem Computer ausgeführt wird.

Nachfolgend soll die Erfindung anhand von Figuren ohne Beschränkung des allgemeinen Erfindungsgedankens näher erläutert werden. Dabei zeigt:
- Figur 1: ein Flussdiagramm des vorgeschlagenen Verfahrens.
- Figur 2: erläutert den ersten Verfahrensschritt des vorgeschlagenen Verfahrens.
- Figur 3: erläutert den zweiten Verfahrensschritt des vorgeschlagenen Verfahrens.
- Figur 4: erläutert den vierten Verfahrensschritt des erfindungsgemäßen Verfahrens.
- Figur 5: zeigt eine beispielhafte Ausführungsform eines Trabekels.
- Figuren 6, 7A und 7B: zeigen einen Sessel als Beispiel einer mechanischen Komponente gemäß der vorliegenden Erfindung.

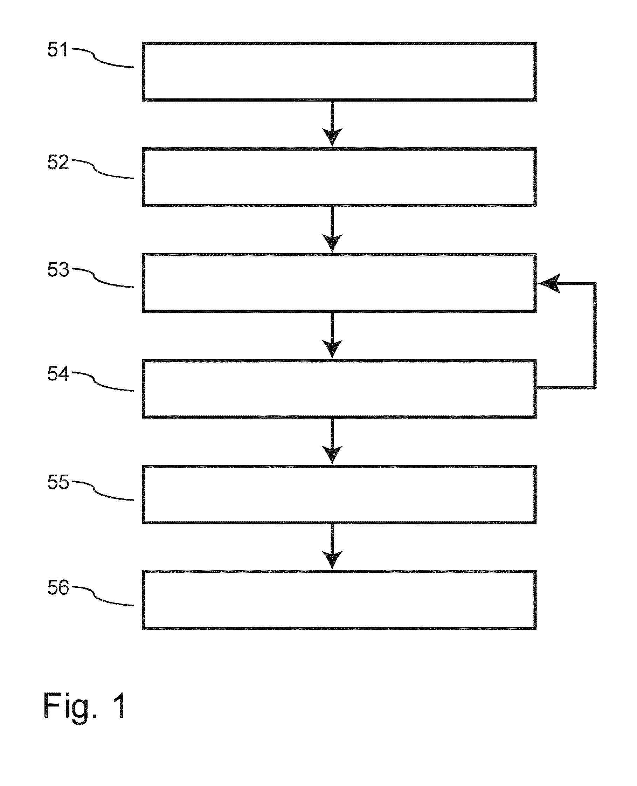

Figur 1 zeigt ein Flussdiagramm des vorgeschlagenen Verfahrens. Im ersten Verfahrensschritt 51 wird die Außenkontur der mechanischen Komponente festgelegt. Die äußere Form und/oder die Größe der mechanischen Komponente bestimmt sich in der Regel nach deren Funktion bzw. nach der Lage, Form und Größe angrenzender Bauteile, mit welchen die mechanische Komponente zusammenwirken muss. Die Außenkontur kann zu Beginn des Verfahrens als gedankliche Linie bzw. Einhüllende der mechanischen Komponente vorgegeben sein, wenn bei der fertigen Komponente eine vollständig geschlossene Oberfläche nicht gefordert ist. Sofern aufgrund der Funktion eine geschlossene Oberfläche notwendig ist, kann im ersten Verfahrensschritt 51 die Außenkontur auch bereits mit einer vorgebbaren Wandstärke versehen sein.

Im zweiten Verfahrensschritt 52 wird das Volumen der mechanischen Komponente in eine Mehrzahl von Zellen diskretisiert. In einigen Ausführungsformen der Erfindung können die Zellen eine vorgebbare Symmetrie und/oder eine vorgebbare Größe aufweisen. Beispielsweise können die Zellen eine polygonale Grundfläche aufweisen. Die Zellen können symmetrisch sein, d.h. genauso hoch wie breit. In anderen Ausführungsformen der Erfindung können die Zellen eine größere Höhe aufweisen als deren Breite. In einigen Ausführungsformen der Erfindung ist die Größe bzw. das Volumen aller Zellen gleich gewählt, so dass nach Abschluss des Konstruktionsverfahrens eine regelmäßige Struktur erhalten wird, d.h. zwei benachbarte Strukturelemente können durch einen konstanten Vektor ineinander überführt werden.

Nachfolgend wird der dritte Verfahrensschritt 53 ausgeführt. Im Verfahrensschritt 53 wird die mechanische Spannung in zumindest einer Zelle unter zumindest einer Belastung berechnet. Die Belastung kann dabei statisch oder dynamisch aufgeprägt sein. Im Normalfall wird die Belastung durch die geplante Verwendung der mechanischen Komponente vorgegeben. In einigen Ausführungsformen der Erfindung kann die mechanische Komponente mehreren Lastfällen unterworfen sein. In diesem Fall kann das Verfahren mehrfach durchlaufen werden, so dass die Struktur der mechanischen Komponente für mehrere Lastfälle optimiert wird.

Zur Bestimmung der mechanischen Spannung in zumindest einer Zelle kann zunächst ein Elastizitätsmodul des als Kontinuum betrachteten Innenvolumens angenommen werden. Dieser Vorgabewert kann entweder willkürlich gewählt sein oder aufgrund von Vorversuchen, Vorerfahrungen und/oder aufgrund des für die Fertigung der mechanischen Komponente geplanten Materials weiter eingeschränkt werden.

Im vierten Verfahrensschritt 54 wird zumindest eine Zelle durch zumindest ein Strukturelement ersetzt. In einigen Ausführungsformen der Erfindung können in Abhängigkeit der Belastung mehrere Strukturelemente in eine Zelle eingefügt werden, so dass bei größerer mechanischer Spannung mehr Strukturelemente vorhanden sind als bei geringerer mechanischer Spannung. In anderen Ausführungsformen der Erfindung kann jede Zelle durch genau ein Strukturelement ersetzt werden, welches jedoch in Größe, Querschnitt, dem Anteil des ausgefüllten Volumens oder in der Form an die jeweilige mechanische Spannung angepasst ist. Im Extremfall kann zur Aufnahme der größten mechanischen Spannungen eine Zelle vollständig mit Material aufgefüllt sein. Ebenso kann eine Zelle mit der geringsten mechanischen Spannung durch das kleinste denkbare Strukturelement gefüllt werden, nämlich ein Leerelement. Sofern die mechanische Komponente nach der erstmaligen Durchführung des vierten Verfahrensschrittes noch nicht tragfähig ist, können die Verfahrensschritte 53 und 54 wiederholt durchgeführt werden, bis entweder alle Zellen durch zumindest ein Strukturelement ausgefüllt sind oder aber die mechanische Komponente so stabil ist, dass sie den im Einsatz auftretenden mechanischen Belastungen Stand hält, auch wenn einzelne Zellen vollständig materialfrei sind.

Im Anschluss an den vierten Verfahrensschritt kann sich ein optionaler fünfter Verfahrensschritt 55 anschließen. Im Verfahrensschritt 55 können die Strukturelemente ihrerseits wieder diskretisiert werden, so dass die in den vorhergehenden Verfahrensschritten generierte Mikrostruktur der mechanischen Komponente rechnerisch überprüft werden kann. Hierzu kann die mechanische Spannung in zumindest einem Strukturelement unter zumindest einer vorgebbaren Belastung bestimmt werden.

Um die mechanische Komponente zu fertigen, können im optionalen sechsten Verfahrensschritt 56 die in den vorhergehenden Verfahrensschritten generierten Strukturdaten an ein generatives Fertigungsverfahren ausgegeben werden. Beispielsweise kann die mechanische Komponente durch Lasersintern, selektives Laserschmelzen oder dreidimensionales Drucken gefertigt werden. Ein solches generativ gefertigtes Bauteil kann entweder als Prototyp oder als Kleinserie bzw. Einzelstück Verwendung finden.

Zur Bestimmung der mechanischen Spannung im Verfahrensschritt 53 oder im optionalen Verfahrensschritt 55 kann beispielsweise eine Finite-Elemente-Methode, eine Finite-Volumen-Methode eine andere Modellierungsmethode verwendet werden. Dementsprechend stellt die Zelle ein Volumen, ein Flächenelement oder ein Partikel dar. Das Grundkonzept des erfindungsgemäßen Verfahrens ändert sich dadurch jedoch nicht.

Zumindest einige der Verfahrensschritte des vorgeschlagenen Verfahrens können in Form einer Software auf einem Computer ausgeführt werden. Eine entsprechende Software kann als computerlesbares Medium oder als elektrische oder optische Signalfolge vorliegen.

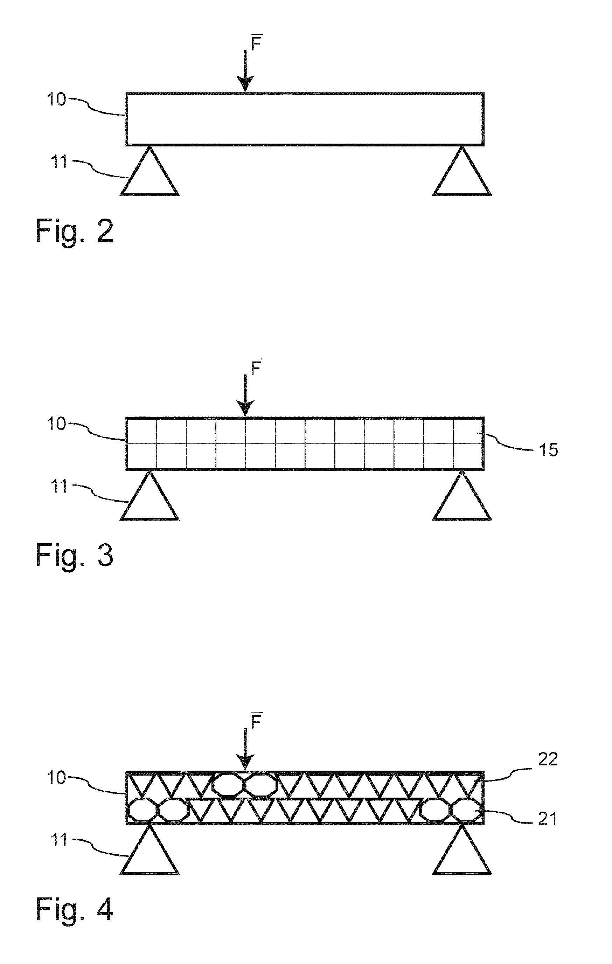

Anhand der Figuren 2 bis 4 wird nochmals das erfindungsgemäße Verfahren an einem einfachen Beispiel erläutert. Dabei zeigt Figur 2 einen auf zwei Auflagern 11 gelagerten Druckbalken 10 als einfaches Beispiel einer mechanischen Komponente. Die mechanische Komponente wird von einer Kraft F belastet. Die mechanische Komponente 10 könnte aus Vollmaterial gefertigt werden, was dieser jedoch ein hohes Gewicht verleiht. Daher soll mit dem erfindungsgemäßen Verfahren eine innere Struktur der Komponente 10 bestimmt werden, welche einerseits das Gewicht der mechanischen Komponente reduziert und andererseits die Belastbarkeit der Komponente nicht unzulässig einschränkt.

Figur 2 zeigt das Modell der mechanischen Komponente 10 nach Durchführung des ersten Verfahrensschrittes, d.h. nachdem die Außenkontur 12 festgelegt wurde.

In Figur 3 ist die mechanische Komponente nach Durchführung des zweiten Verfahrensschrittes 52 dargestellt. Erkennbar ist, dass das Volumen der mechanischen Komponente 10 in eine Mehrzahl von Zellen 15 diskretisiert wurde. Im dargestellten Ausführungsbeispiel wurde die Komponente 10 in vierundzwanzig Zellen 15 diskretisiert. Selbstverständlich ist diese Zahl rein willkürlich gewählt. Insbesondere ist die Zahl aus Gründen der Anschaulichkeit nicht zu groß gewählt, so dass die einzelne Zelle 15 in Figur 3 und 4 noch gut erkennbar bleibt.

Schließlich wird der dritte und vierte Verfahrensschritt durchgeführt, d.h. es werden mechanische Spannungen in den Zellen 15 unter der Last F ermittelt. Schließlich wird jede Zelle 15 durch ein Strukturelement 21 oder 22 ersetzt. Dabei werden Zellen, in welchen eine große mechanische Belastung auftritt, durch ein erstes Strukturelement 21 ersetzt und Zellen mit geringerer mechanischer Spannung durch ein zweites Strukturelement 22. Wie aus Figur 4 erkennbar ist, füllt das erste Strukturelement 21 ein größeres Volumen der Zelle 15 aus, so dass die mechanische Komponente 10 in diesen Teilvolumina steifer wird. Das zweite Strukturelement 22 füllt demgegenüber ein geringeres Volumen aus, so dass die mechanische Komponente 10 an diesen Stellen ein geringeres Gewicht aufweist. Insgesamt kann so gegenüber einer massiven Ausführung Gewicht eingespart werden, ohne dass die mechanische Komponente 10 unter der Last F versagt.

Die in Figur 4 dargestellten Strukturelemente 21 und 22 sind rein schematisch dargestellt. Es könnte sich beispielsweise um Polyeder handeln. Die dargestellten Polygone können jedoch auch als Symbole für Strukturelemente mit völlig anderer geometrischer Struktur angesehen werden. In einigen Ausführungsformen der Erfindung können auch drei oder mehr verschiedene Strukturelemente eingesetzt werden. Die Auswahl eines spezifischen Strukturelementes kann in Abhängigkeit der mechanischen Spannung durch Festlegen eines Schwellenwertes erfolgen.

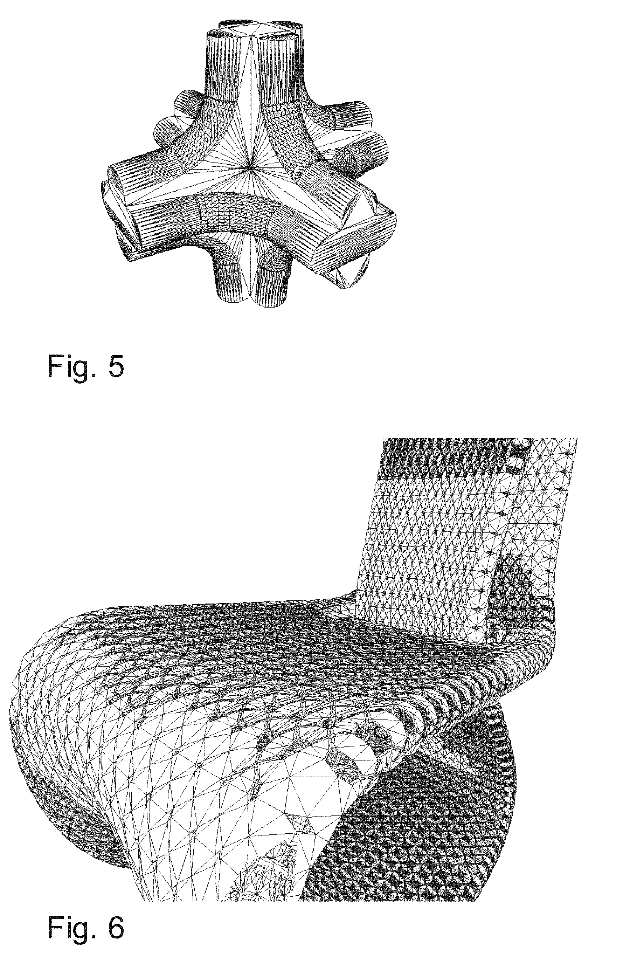

Figur 5 zeigt ein mögliches Strukturelement, welches im Zusammenhang mit der vorliegenden Erfindung verwendbar ist. Das Strukturelement 20 gemäß Figur 5 wird in der nachfolgenden Beschreibung als Trabekel bezeichnet. Das Trabekel besitzt eine faser- bzw. balkenförmige Struktur und weist an seinen Grenzen Anschlussflächen 201 auf. Über die Anschlussflächen 201 können Kräfte in das Trabekel eingeleitet und/oder abgetragen werden. Die Trabekel 20 können unterschiedliche Querschnitte aufweisen, so dass Trabekel mit größerem Querschnitt eingesetzt werden können, wenn größere mechanische Spannungen auftreten und Trabekel mit geringerem Querschnitt können in Raumbereichen mit geringeren mechanischen Anforderungen eingesetzt werden.

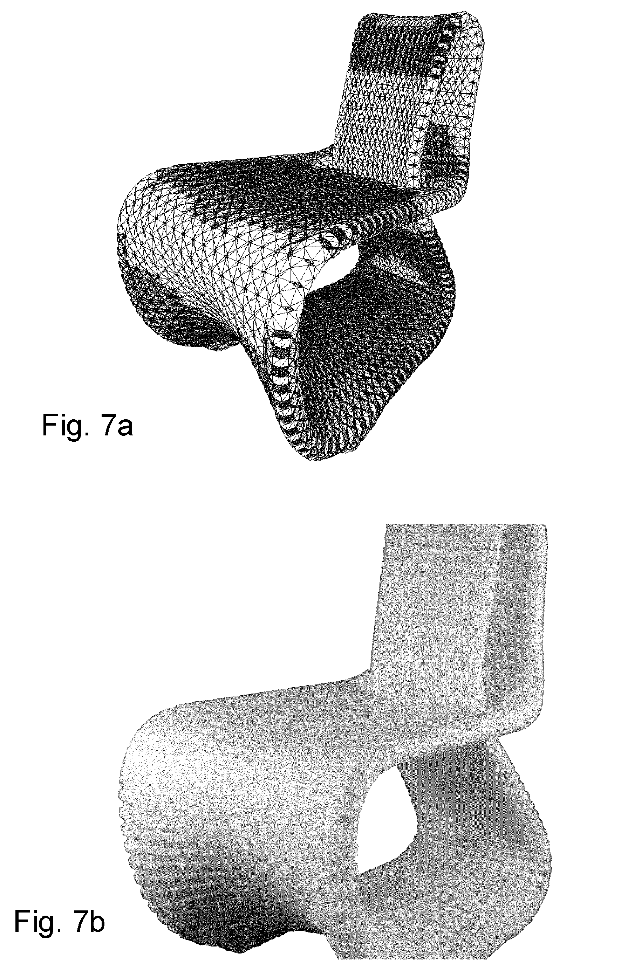

Anhand der Figuren 6, 7A und 7B wird nochmals ein Beispiel für das erfindungsgemäße Verfahren gezeigt. Wie am besten anhand von Figur 7A ersichtlich ist, handelt es sich beim gewählten Beispiel um einen Sessel bzw. Stuhl in Form einer verschlungenen, asymmetrischen Acht. Da eine vollständig geschlossene Sitzfläche 102, eine geschlossene Rückenlehne 103 oder eine geschlossene Standfläche 101 nicht zwingend erforderlich ist, wurde die Außenkontur des Möbelstückes nur als Einhüllende vorgegeben. Mit Hilfe des erfindungsgemäßen Verfahrens wurde der zwischen den Einhüllenden verbliebene Raum mit Strukturelementen aufgefüllt, so dass der Sessel den zu erwartenden Belastungen Stand hält. Als Strukturelement wurden die in Figur 5 gezeigten Trabekel verwendet, wobei Trabekel mit unterschiedlicher Querschnittsfläche bzw. unterschiedlichem Anteil des ausgefüllten Volumens zur Verfügung stehen.

Wie man intuitiv erwarten würde, ist die Belastung im Bereich des Überganges 104 der Sitzfläche 102 in die Bodenfläche 101 besonders groß. Das erfindungsgemäße Verfahren kommt zum selben Ergebnis und setzt an dieser Stelle Trabekel 20 ein, welche einen großen Anteil des Volumens der jeweiligen Zelle ausfüllen. Dadurch ergibt sich im Bereich des Überganges 104 eine nahezu geschlossene Oberfläche des Stuhls. Im Bereich der Bodenfläche 101 und der Sitzfläche 102 ist die Belastung erheblich geringer, so dass dort eine netz- bzw. siebartige Struktur erkennbar ist, da die Trabekel 20 nicht die gesamte Fläche bzw. das gesamte Volumen ausfüllen. Ähnliche Belastungsspitzen erkennt man auch im Bereich der Rückenlehne 103, wo erhöhter Materialeinsatz wiederum zu einer geschlossenen Oberfläche des Möbelstücks führt.

Auf diese Weise kann der Materialeinsatz minimiert werden, so dass sich das Möbelstück durch geringes Gewicht auszeichnet. Andererseits wird durch Versteifung an den notwendigen Stellen die Gebrauchstauglichkeit und die Festigkeit nicht eingeschränkt. Da das Volumen des Möbelstückes in gleiche Teilvolumina unterteilt ist, entsteht eine regelmäßige Struktur, welche analytischen oder numerischen Berechnungsverfahren gut zugänglich ist, um die höchst zulässige Belastung und/oder die Betriebsfestigkeit zu bestimmen.

In gleicher Weise, wie für den Druckbalken und den Sessel gezeigt, kann das Verfahren selbstverständlich für beliebige andere mechanisch belastete Komponenten durchgeführt werden. Selbstverständlich ist die Erfindung daher nicht auf die in den Figuren dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Merkmale definieren, so dient diese Bezeichnung der Unterscheidung zweier gleichartiger Merkmale, ohne eine Rangfolge festzulegen.

## Patentansprüche

1. Verfahren zur Konstruktion mechanischer Komponenten (10), enthaltend die folgenden Schritte:
Festlegen (51) der Außenkontur (12) der mechanischen Komponente (10);
Diskretisieren (52) des Volumens der mechanischen Komponente (10) in eine Mehrzahl von Zellen (15);
Bestimmen (53) der mechanischen Spannung in zumindest einer Zelle (15) unter zumindest einer Belastung (F);
Ersetzen (54) von zumindest einer Zelle (15) durch zumindest ein Strukturelement (20, 21, 22),
**dadurch gekennzeichnet, dass**
die Strukturelemente ausgewählt sind aus Polyedern und/oder Trabekeln und/oder non-uniform rational B-Splines, wobei ein Polyeder kleiner ist als das Volumen einer Zelle (15).

2. Verfahren nach Anspruch 1, **dadurch gekennzeichnet, dass** jede einzelne Zelle (15) aus der Mehrzahl von Zellen eine identische Größe aufweist

3. Verfahren nach Anspruch 1 oder 2, **dadurch gekennzeichnet, dass** jede Zelle (15) durch genau ein Strukturelement (20, 21, 22) ersetzt wird.

4. Verfahren nach einem der Ansprüche 1 bis 3, **dadurch gekennzeichnet, dass** das in eine Zelle (15) einzusetzende Strukturelement (20, 21, 22) aus einer Mehrzahl möglicher Strukturelemente (20, 21, 22) ausgewählt wird.

5. Verfahren nach Anspruch 4, gekennzeichnet, dass die Strukturelemente (20, 21, 22) sich in ihrer Größe und/oder in ihrer Form und/oder in ihrem Querschnitt und/oder in ihrem Material und/oder im Anteil des ausgefüllten Volumens unterscheiden.

6. Verfahren nach einem der Ansprüche 1 bis 4, **dadurch gekennzeichnet, dass** zumindest ein Polyeder (21, 22) ausgewählt ist aus einem Tetraeder (22) und/oder einem Hexaeder und/oder einem Oktaeder (21) und/oder einem Dodekaeder und/oder einem Ikosaeder.

7. Verfahren nach einem der Ansprüche 1 bis 6, **dadurch gekennzeichnet, dass** einige Verfahrensschritte (53, 54) zyklisch wiederholt werden, bis alle Zellen (15) im Volumen der mechanischen Komponente durch zumindest ein Strukturelement (20, 21, 22) ausgefüllt sind.

8. Verfahren nach einem der Ansprüche 1 bis 7, weiterhin enthaltend den folgenden Schritt: Diskretisieren (55) der Strukturelemente (20, 21, 22) in eine Mehrzahl von Zellen (15) und Bestimmen der mechanischen Spannung in zumindest einem Strukturelement (20, 21, 22) unter zumindest einer vorgebbaren Belastung.

9. Verfahren nach einem der Ansprüche 4 bis 8, **dadurch gekennzeichnet, dass** das einzusetzende Strukturelement (20, 21, 22) aus einer Mehrzahl möglicher Strukturelemente (20, 21, 22) in Abhängigkeit der für die jeweilige Zelle (15) berechneten mechanischen Spannung ausgewählt wird.

10. Verfahren nach einem der Ansprüche 1 bis 9, **dadurch gekennzeichnet, dass** das Bestimmen (53) der mechanischen Spannung in zumindest einer Zelle (15) unter zumindest einer Belastung mittels einer Finiten-Elemente-Methode und/oder einer Finiten-Volumen-Methode und/oder einer Smoothed-Particles-Hydrodynamic-Methode erfolgt.

11. Verfahren nach einem der Ansprüche 1 bis 10, weiterhin enthaltend den folgenden Schritt: Ausgeben (56) der in den vorhergehenden Schritten ermittelten Struktur an ein generatives Fertigungsverfahren.

12. Verfahren nach einem der Ansprüche 1 bis 11, **dadurch gekennzeichnet, dass** die mechanische Komponente ein Volumen von weniger als 50000 cm3 oder von weniger als 10000 cm3 oder von weniger als 5000 cm3 oder von weniger als 1000 cm3 oder von weniger als 500 cm3 oder von weniger als 100 cm3 oder von weniger als 10 cm3 aufweist.

13. Datenträger mit darauf gespeicherten Daten oder für die Übersendung über ein Computernetz geeignete, Daten repräsentierende Signalfolge, wobei die Daten ein Programm zur Durchführung eines Verfahrens nach einem der Ansprüche 1 bis 12 zum Ablauf auf einem Benutzerrechner darstellen.

14. Computerprogramm, welches einen Programmkode enthält, welcher daran angepasst ist, alle Schritte eines Verfahrens nach einem der Ansprüche 1 bis 12 durchzuführen, wenn das Programm auf einem Computer läuft.
